# EUROPÄISCHE PATENTSCHRIFT

(11) **EP 3 214 909 B1**
(45) Veröffentlichungstag und Bekanntmachung des Hinweises auf die Patenterteilung: **29.12.2021**
(21) Anmeldenummer: 17157562.4
(22) Anmeldetag: 23.02.2017
(51) Int. Cl.: H05K 5/06, G01D 11/24, H05K 5/00

(54) **ELEKTRONISCHES BAUTEIL UND VERFAHREN ZU DESSEN HERSTELLUNG**
ELECTRONIC DEVICE AND METHOD OF MANUFACTURE THEREFOR
DISPOSITIF ÉLECTRONIQUE ET SON PROCÉDÉ DE FABRICATION

(30) Priorität: 03.03.2016 DE 202016101136 U
(43) Veröffentlichungstag der Anmeldung: 06.09.2017
(73) Patentinhaber: Tridonic GmbH & Co. KG, 6851 Dornbirn (AT)
(72) Erfinder: Nesensohn, Christian, 6840 Götzis (AT); Wynnyczenko, Oliver, 6890 Lustenau (AT)
(74) Vertreter: Kiwit, Benedikt

(56) Entgegenhaltungen:
- EP-A1- 2 919 567
- DE-A1-102009 016 675
- DE-U1-202012 101 143

## Beschreibung

Die vorliegende Erfindung betrifft ein elektronisches Bauteil, insbesondere einen Treiber für eine Leuchte, sowie ein Verfahren zu dessen Herstellung. Die Erfindung betrifft ferner eine Leuchte mit diesem elektronischen Bauteil und entsprechenden Leuchtmitteln.

Aus dem Stand der Technik sind vergleichbare elektronische Bauteile, insbesondere Treiber, Konverter, Vorschaltgeräte und dergleichen für Leuchten, bekannt. Diese elektronischen Bauteile - beispielsweise Treiber - weisen in der Regel eine Leiterplatte mit entsprechenden elektronischen Komponenten auf. Diese Leiterplatte ist in der Regel in einem Gehäuse angeordnet. Das Gehäuse dient dabei insbesondere der Aufnahme und dem Schutz der Leiterplatte und elektronischen Komponenten sowie der Befestigung des Treibers. Zum elektrischen Anschluss der Leiterplatte weist das Gehäuse in der Regel eine Öffnung auf, über die die entsprechenden Kabel / Drähte geführt sind.

Häufig ist es gewünscht, das Gehäuse entsprechend einer definierten Schutzklasse dicht abzuschließen. Hierzu wird der die Leiterplatte aufweisende Innenraum des Gehäuses wenigstens teilweise mit einer entsprechenden Vergussmasse vergossen. Bei einseitig offenen Gehäusen dient diese eine Öffnung dem Einsetzen der Leiterplatte mit den elektronischen Komponenten, der Einführung der Verkabelung sowie auch dem Einbringen der Vergussmasse. Solche Treiber können beispielsweise in der Schutzklasse IP 67 bereitgestellt werden.

Es hat sich in der Praxis als vorteilhaft herausgestellt, die Kabelzuführung zum Treiber sowie die Kabelwegführung vom Treiber (beispielsweise zu einem Leuchtmittel hin) an gegenüberliegenden Enden des Treibers bzw. des Gehäuses vorzusehen. Diese Anordnung erleichtert zum Einen den Anschluss der Kabel und das Handling des Treibers. Zum Anderen weist ein beidseitig offenes Gehäuse ein einfaches technisches Design auf. Bei derartig zweiseitig offenen Gehäusen stellt sich allerdings das Problem, das Gehäuseinnere ohne Materialverlust auf sichere und einfache Weise mit einer Vergussmasse zu vergießen. Um das Gehäuse und somit die dafür vorgesehenen elektronischen Komponenten entsprechend zu vergießen, müssen die Öffnungen möglichst gut verschlossen sein, um ein Herausfließen der Vergussmasse während des Vergießprozesses zu unterbinden.

Als Vergussmasse kommt beispielsweise Asphalt in Betracht, welches vergleichsweise zähflüssig ist. Bei anderen Vergussmaterialien, wie beispielsweise Silikon oder Polyurethan, ist aufgrund ihrer geringen Viskosität eine besonders gute Abdichtung der Öffnungen erforderlich, um ein Herausfließen des Vergussmaterials bis zu dessen Erhärten zu vermeiden.

Im Stand der Technik gibt es elektronische Bauteile, welche zum Vergießen des beidseitig offenen Innenraums des Gehäuses an den gegenüberliegenden Seiten den jeweiligen Öffnungen zugewandt Schottwände aufweisen. Diese Schottwände sind als separate Teile bereitgestellt. Nach dem Einsetzen der Leiterplatten mit elektronischen Komponenten in das Gehäuse werden die Schottwände entsprechend den jeweiligen Öffnungen zugeordnet eingesetzt. Der somit durch die beiden Schottwände und das Gehäuse begrenzte Bereich wird dann mit einer Vergussmasse ausgefüllt. Um die Schottwände sicher zu halten, können diese in entsprechend ausgebildeten Profilaufnahmen des Gehäuses eingesetzt werden. Nach dem Einsetzen der Schottwände zum seitlichen Verschließen des Gehäuses und ggf. Aufsetzen eines Gehäusedeckels, nachdem die Schottwände eingesetzt wurden, kann das Gehäuse mit der entsprechenden Vergussmasse vergossen werden.

Die für den Vergießvorgang vorzusehenden Schottwände müssen also separat eingesetzt werden, was einen zusätzlichen Montage- bzw. Herstellungsaufwand erfordert. Des Weiteren stehen diese Schottwände nach der Herstellung des elektronischen Bauteils während der gesamten Lebensdauer in dem Bauteil bereit, ohne einen zusätzlichen Nutzen zu erfüllen. In der Regel sind die Schottwände zudem flexibel ausgebildet und müssen für eine entsprechend widerstandsfähige Ausgestaltung zum Zurückhalten der Vergussmasse vergleichsweise dick ausgebildet sein.

Es ist somit eine Aufgabe der vorliegenden Erfindung, ein elektronisches Bauteil sowie ein Verfahren zu dessen Herstellung bereitzustellen, die die Nachteile des Standes der Technik überwinden.

Diese Aufgabe wird durch den Gegenstand der unabhängigen Ansprüche gelöst. Die abhängigen Ansprüche bilden den zentralen Gedanken der Erfindung in besonders vorteilhafter Weise weiter.

Gemäß einem ersten Aspekt betrifft die Erfindung ein elektronisches Bauteil. Hierbei kann es sich beispielsweise um einen Treiber, einen Konverter, ein Vorschaltgerät oder dergleichen für eine Leuchte handeln. Das elektronische Bauteil weist ein Gehäuse mit zwei gegenüberliegenden Öffnungen auf. Des Weiteren weist das elektronische Bauteil eine Leiterplatte zur Aufnahme elektronischer Komponenten auf, welche in dem Gehäuse angeordnet ist und sich wenigstens teilweise zwischen den Öffnungen des Gehäuses erstreckt. Ebenso weist das elektronische Bauteil eine Vergussmasse auf, welche einen definierten Teilbereich zwischen den Öffnungen des Gehäuses ausfüllt. Der Teilbereich ist zu den Öffnungen hin durch jeweils eine Schottwand räumlich begrenzt, welche zusammen mit dem Gehäuse den Teilbereich im Wesentlichen umfangsseitig geschlossen begrenzen. Durch das Vorsehen der Schottwände wird es somit ermöglicht, dass der Teilbereich mit der Vergussmasse vergossen werden kann. Wenigstens eine der Schottwände ist als Sub-Leiterplatte ausgebildet.

Durch den Einsatz einer Sub-Leiterplatte als Schottwand wird es ermöglicht, einerseits die bisher ungenutzten Schottwände durch tatsächlich nutzbare Komponenten zu ersetzen, während gleichzeitig die Sub-Leiterplatte(n) zum Zurückhalten der eingebrachten (flüssigen) Vergussmasse bereitgestellt ist(sind), wodurch ein sicheres Vergießen des Gehäuses erhalten bleibt. Auch können beispielsweise auf der Sub-Leiterplatte elektronische Komponenten vorgesehen sein, welche bisher auf der Hauptleiterplatte vorgesehen waren. Insofern ergibt sich eine Bauraumoptimierung, da auch die Sub-Leiterplatten der Aufnahme der elektronischen Komponenten dienen und somit der gesamte Bauraum des Gehäuses reduziert werden kann.

In einer bevorzugten Ausgestaltungsform ist die Sub-Leiterplatte mechanisch und/oder elektrisch mit der Leiterplatte verbunden. Durch die elektrische Verbindung kann folglich eine Bauraum-optimierte, abgewinkelte, nutzbare Leiterplattenoberfläche bereitgestellt werden. Die mechanische Verbindung der Sub-Leiterplatte mit der Leiterplatte ermöglicht es, zusätzlich den Montageaufwand des elektronischen Bauteils zu reduzieren, da die als Schottwände dienenden Sub-Leiterplatten nun nicht mehr nachträglich in das Gehäuse eingesetzt werden müssen, sondern automatisch beim Einsetzen der Leiterplatte entsprechend platziert werden, um zusätzlich ihrem weiteren Zweck des Zurückhaltens von Vergussmasse zu dienen. Im Übrigen können auch etwaige nicht als Sub-Leiterplatten ausgebildete Schottwände mechanisch mit der Leiterplatte verbunden sein. Die Verbindung der Schottwände, wenigstens der Sub-Leiterplatte(n), mit der Leiterplatte wird bevorzugt durch eine Lötverbindung bereitgestellt. Somit kann die Verbindung der Leiterplatte mit den Schottwänden (z.B. Sub-Leiterplatte(n)) auf herkömmliche Weise bereitgestellt werden. Zudem können Lücken zwischen den Leiterplatten aufgefüllt und somit geschlossen werden.

Gemäß einer bevorzugten Ausgestaltungsform stehen die Schottwände, wenigstens die Sub-Leiterplatte(n), vorzugsweise senkrecht auf der Leiterplatte. Bevorzugt erstrecken sich also die Schottwände im Wesentlichen parallel zur Erstreckungsebene der zugeordneten Öffnung, um somit eine möglichst gute räumliche Abgrenzung des Teilbereichs nach außen hin zu erzielen, um die Vergussmasse bis zum Erhärten sicher zurückzuhalten. Die entsprechende Schottwand weist hierzu bevorzugt eine Kontur auf, welche im Wesentlichen derjenigen der zugeordneten Öffnung entspricht, um letztere bestmöglich und vorzugsweise umlaufend zu verschließen.

Vorzugsweise die Schottwände, erfindungsgemäß aber wenigstens eine Sub-Leiterplatte(n), sind wenigstens teilweise seitlich in einer Nut des Gehäuses aufgenommen bzw. geführt. Dies erleichtert zum Einen das Platzieren der Schottwände und ermöglicht zudem eine verbesserte Abdichtung des Teilbereichs nach außen.

Die Leiterplatte und/oder die Sub-Leiterplatte(n) weisen bevorzugt ferner elektronische Komponenten auf. Diese können an beliebigen Stellen der Leiterplatte und/oder Sub-Leiterplatte(n) vorgesehen sein und für sich genommen oder übergreifend insgesamt beispielsweise eine Treiberschaltung o.ä. bilden.

In einer besonders bevorzugten Ausgestaltungsform können beispielsweise auf den Sub-Leiterplatten insbesondere diejenigen elektronischen Komponenten vorgesehen sein, welche für eine Außenanwendung des elektronischen Bauteils vorzusehen sind. Auf diese Weise wird es beispielsweise ermöglicht, eine Leiterplatte bereitzustellen, welche für alle denkbaren Anwendungen herangezogen werden kann (insbesondere als Leuchtentreiber). Soll nun ein entsprechendes Gehäuse bzw. ein Konverter für den Außenbereich bereitgestellt werden, so können in einfacher Weise die wenigstens teilweise als Sub-Leiterplatte ausgebildeten Schottwände vorgesehen werden. Auf diese Weise kann zugleich eine entsprechend Schottwand für das Vergießen des Gehäuses bereitgestellt und andererseits zusätzlich die Komponenten für den Außenbereich bzw. Außenbetrieb auf der Leiterplatte montiert werden. Auf diese Weise kann eine besonders effektive Ausnutzung der Ressourcen ermöglicht werden.

Gemäß einer weiteren Ausführungsform kann(können) die Sub-Leiterplatte(n) ein RFID-Element vorzugsweise mit Mikrochip und Antenne aufweisen. Wenigstens ein Teil des RFID-Elements, insbesondere die Antenne, kann dann an der der Vergussmasse abgewandten und vorzugsweise nach außen gewandten Seite der Sub-Leiterplatte vorgesehen sein. Auch ist es denkbar, andere Elemente neben RFID-Elementen bzw. NFC-Elementen entsprechend vorzusehen. Weist die Sub-Platine ein RFID-Element auf, so kann beispielsweise durch eine Kupferbahn auf der Sub-Leiterplatte eine Antenne eines entsprechenden Elements bereitgestellt werden, welcher einer drahtlosen Funkübertragung dient. Dies kann insbesondere dann von Vorteil sein, wenn das Gehäuse selbst aus Metall hergestellt ist und ein entsprechend vorgesehenes Sub-Print zur Bereitstellung einer Antenne andernfalls innerhalb des Gehäuses eine deutlich verringerte Funkleistung hätte. Um somit die Funkleistung des RFID-Elements in ausreichender Weise bereitzustellen, kann die (aufgedruckte) Antenne in bevorzugter Weise auf der Sub-Leiterplatte derart bereitgestellt werden, dass sie nach außen freiliegt; also der Vergussmasse bzw. dem Teilbereich abgewandt und der Öffnung zugewandt vorgesehen ist.

Gemäß einer weiteren Ausführungsform kann(können) die Sub-Leiterplatte(n) auch Filterkomponenten einer Überspannungsschutzeinheit (Burst und Surge Protection Unit) aufweisen. Dabei kann es sich beispielsweise um Mantelstromfilter (VDRs), Anschlüsse, Sicherungen, etc. handeln. Auf diese Weise kann die gleiche Anordnung (Elektronisches Bauteil) bspw. einerseits für eine Indoor-Anwendung verwendet werden, die nicht zwingend eine Vergussmasse aufweisen muss und bei der die Anforderungen bzgl. Überspannungsschutz (Burst und Surge Protection) niedriger sind. Andererseits kann ein derart mit Filterkomponenten bestücktes Gehäuse gleichzeitig auch für höheren Überspannungsschutz (Burst und Surge Protection) - bspw. in einer Outdor-Anwendung - ausgelegt sein und steht dann mit Vergussmasse entsprechend ausgefüllt bereit.

Wenigstens auf einer vorzugsweise auf gegenüberliegenden Seiten der Leiterplatte erstreckt sich der entsprechende Bereich der Leiterplatte über die Schottwände nach außerhalb des vergossenen Teilbereichs. Die Leiterplatte steht somit an einer oder gegenüberliegenden Seiten aus dem vergossenen Bereich zu den Öffnungen hin bzw. aus den Öffnungen heraus vor. Diese Bereiche können in definierter Weise genutzt werden. Beispielsweise können auf diesem Bereich bestimmte elektronische Komponenten, welche von außen zugänglich sein müssen, bereitgestellt sein. Alternativ oder zusätzlich können auf diesen Bereichen Anschlusselemente zum vorzugsweise lösbaren Vorsehen von Leitern bereitgestellt sein.

Ganz allgemein kann vorzugsweise die Leiterplatte und/oder Sub-Leiterplatte(n) wenigstens ein Anschlusselement zum vorzugsweise lösbaren Vorsehen von Leitern aufweisen. Das Anschlusselement ist dabei vorzugsweise außerhalb des vergossenen Teilbereichs vorgesehen; also beispielsweise auf dem vorstehenden (exponierten) Bereich der Leiterplatte oder der (exponierten) Außenseite der Sub-Leiterplatte(n).

In einer bevorzugten Ausgestaltungsform kann das Gehäuse zweiteilig ausgebildet sein, so dass eine Montageseite zum Anordnen der Leiterplatte und/oder Schottwände (einschließlich Sub-Leiterplatte(n)) in dem Gehäuse wahlweise freigelegt werden kann. Über die verschließbare Gehäuseseite kann somit beispielsweise die mit den Sub-Leiterplatten mechanisch verbundene Leiterplatte derart eingesetzt werden, dass die Sub-Leiterplatten bzw. Schottwände in entsprechenden seitlichen Nuten geführt in dem Gehäuse aufgenommen werden und somit definiert platziert für einen Vergießvorgang bereitgestellt sind.

Die Vergussmasse kann bevorzugt eine Basismatrix wie beispielsweise Asphalt, Silikon, insbesondere Silikonharz, oder Polyurethan sein. Die Vergussmasse weist dabei vorzugsweise Füllpartikel auf. Dies können bspw. Füllpartikel zur Beeinflussung und insbesondere Einstellung der Viskosität der Basismatrix sein. Hierzu kommen bspw. Füllpartikel wie vorzugsweise TiO2, SiO2, Al2O3, Polymerteilchen, wie z.B. Latex, und/oder Glasteilchen in Frage. Auch können Füllpartikel eingesetzt werden, welche (ergänzend) der Erhöhung der Wärmeleitfähigkeit der Vergussmasse dienen. Somit kann eine auf die Anforderungen abgestimmte Vergussmasse bereitgestellt werden.

Das vergossene Gehäuse entspricht bevorzugt einer definierten Schutzklasse, wie beispielsweise (wenigstens) IP 65 und ferner bevorzugt (wenigstens) IP 67.

Das elektronische Bauteil ist bevorzugt ein Treiber, ein Konverter, ein Vorschaltgerät und dergleichen für Leuchten, insbesondere ein LED-Treiber für eine Leuchte.

Gemäß einem weiteren Aspekt der Erfindung betrifft die Erfindung daher ferner eine Leuchte aufweisend ein elektronisches Bauteil gemäß der vorliegenden Erfindung sowie ein Leuchtmittel, insbesondere ein LED, welche(s) zum Betrieb der Leuchte mit dem elektronischen Bauteil elektrisch verbunden ist.

Gemäß einem weiteren Aspekt betrifft die vorliegende Erfindung ferner ein Verfahren zur Herstellung eines elektronischen Bauteils, insbesondere eines elektronischen Bauteils gemäß der vorliegenden Erfindung. Das Verfahren weist hierzu folgende Schritte auf:
- Bereitstellen eines Gehäuses mit zwei gegenüberliegenden Öffnungen,
- Anordnen einer Leiterplatte zur Aufnahme elektronischer Komponenten in dem Gehäuse, so dass sich die Leiterplatte wenigstens teilweise zwischen den Öffnungen des Gehäuses erstreckt,
- Anordnen von Schottwänden in dem Gehäuse derart, dass diese zusammen mit dem Gehäuse (also der Gehäusewand) einen definierten Teilbereich - also im Inneren des Gehäuses - im Wesentlichen umfangsseitig geschlossen begrenzen, indem sie den Teilbereich jeweils zu den Öffnungen hin räumlich begrenzen, wobei wenigstens eine der Schottwände als Sub-Leiterplatte ausgebildet ist, und
- Vergießen des Teilbereichs mit einer Vergussmasse, welche wenigstens den Teilbereich zwischen den Öffnungen des Gehäuses ausfüllt.

Mittels dieses Verfahrens kann ein elektronisches Bauteil hergestellt werden, welches zwei gegenüberliegende Öffnungen beispielsweise zum Zuführen von entsprechenden elektrischen Leitern aufweist, und welches gleichzeitig in einfacher und sicherer Weise - beispielsweise zum Bereitstellen einer definierten Schutzklasse - vergossen wurde. Die Elemente zum Zurückhalten der Vergussmasse an den entsprechenden Öffnungen bilden dabei wenigstens teilweise einen nutzbaren Teil des elektronischen Bauteils, indem sie als Leiterplatten-Elemente beispielsweise zur Aufnahme elektronischer Komponenten bereitgestellt sind.

Die Schottwände, wenigstens die Sub-Leiterplatte(n), wird bevorzugt mit der Leiterplatte mechanisch verbunden, vorzugsweise verlötet, besonders vorzugsweise bveor die Leiterplatte mit den verbundenen Schottwänden bzw. Sub-Leiterplatte(n) in dem Gehäuse angeordnet wird. Auf diese Weise werden die vorzusehenden Schottwände bevorzugt automatisch beim Einsetzen der Leiterplatte in das Gehäuse an einer definierten Stelle bereitgestellt, was folglich den Montageaufwand bzw. Herstellungsaufwand insgesamt verringert.

Die Schottwände, wenigstens die Sub-Leiterplatte(n), können wenigstens teilweise seitlich in eine Nut des Gehäuses eingesetzt werden. Dies führt zu einer sicheren Aufnahme der Schottwände, um einerseits eine definierte Positionierung derselben zu erzielen und andererseits eine verbesserte Dichtfunktion für den Vergießvorgang bereitzustellen. Die Nut kann auch zur sicheren Führung der Leiterplatten beim Einsetzen in das Gehäuse dienen.

Das Gehäuse ist bevorzugt zweiteilig ausgebildet, so dass eine Montageseite zum Anordnen der Leiterplatte und/oder Schottwände (wenigstens der Sub-Leiterplatte(n)) - also dem Einsetzen derselben in das Gehäuse - in dem Gehäuse wahlweise freigelegt wird. Dies ermöglicht ein einfaches Einsetzen der Leiterplatten in das Gehäuse. Das Gehäuse kann dabei wahlweise vor oder nach dem Vergießvorgang mittels des Deckels verschlossen werden.

Dem Schritt des Vergießens des Teilbereichs kann vorzugsweise ein Aushärtungsschritt zum (aktiven) Aushärten der Vergussmasse - beispielsweise unter Einsatz von UV-Bestrahlung - folgen. Vorzugsweise werden der Schritt des Vergießens und der folgende Schritt des Aushärtens mehrfach wiederholt. Beispielsweise können mehrere Aushärtungsschritte bevorzugt abwechselnd zu mehreren Vergießschritten angewendet werden.

Weitere Ausgestaltungsformen der vorliegenden Erfindung werden anhand der Figuren der begleitenden Zeichnungen im Folgenden beschrieben. Es zeigen:
- Fig. 1:: eine Teil-Schnittansicht in Draufsicht auf ein elektronisches Bauteil gemäß einer Ausführungsform der Erfindung,
- Fig. 2:: eine perspektivische Ansicht eines Teils einer Leiterplatte mit Sub-Leiterplatte des erfindungsgemäßen elektronischen Bauteils gemäß Fig. 1 in vereinfachter Darstellung,
- Fig. 3a:: eine Vorderansicht der Leiterplatten gemäß Fig. 2 in Blickrichtung IIIa,
- Fig. 3b:: eine Draufsicht auf die Leiterplatten gemäß Fig. 2 in Blickrichtung IIIb, und
- Fig. 3c:: eine Seitenansicht der Leiterplatten gemäß Fig. 2 in Blickrichtung IIIc.

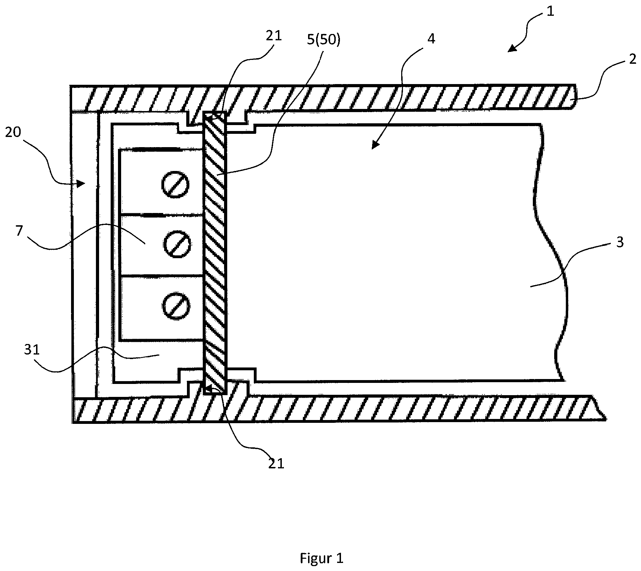

Fig. 1 zeigt ein erfindungsgemäßes elektronisches Bauteil 1 gemäß der vorliegenden Erfindung. Ein solches elektronisches Bauteil 1 kann insbesondere ein Treiber für eine Leuchte (nicht gezeigt) sein. Insbesondere kann es sich hierbei um einen LED-Treiber handeln. Auch andere elektronische Bauteile 1 sind denkbar, wie beispielsweise Konverter, Vorschaltgeräte und dergleichen.

Das elektronische Bauteil 1 weist ein Gehäuse 2 auf. Das Gehäuse 2 kann dabei aus einem für solche Bauteile 1 üblichen Material hergestellt sein. Beispielsweise kommt hier ein Gehäuse 2 aus Metall, Kunststoff oder einem anderen geeigneten Material in Betracht. Die Erfindung ist hierbei nicht auf ein bestimmtes Material beschränkt.

Das Gehäuse 2 weist zwei gegenüberliegende Öffnungen 20 auf, wobei in Fig. 1 lediglich eine Öffnung 20 gezeigt ist. Die entsprechend andere Öffnung befindet sich bei dem Ausführungsbeispiel gemäß der Fig. 1 an der der gezeigten Öffnung 20 gegenüberliegenden Seite des elektronischen Bauteils 1, also in der Zeichenebene auf der rechten Seite der Fig. 1. Die beiden die Öffnung 20 aufweisenden Seiten des Gehäuses 2 bzw. des elektronischen Bauteils 1 können dabei spiegelsymmetrisch aufgebaut sein. Insgesamt kann das gesamte Gehäuse 2 spiegelsymmetrisch aufgebaut sein. Selbstverständlich können diese Seiten bzw. das Gehäuse 2 auch den Anforderungen an das elektronische Bauteil 1 entsprechend individuell ausgestaltet sein.

Wie Fig. 1 zu entnehmen ist, weist das elektronische Bauteil 1 ferner eine Leiterplatte 3 zur Aufnahme elektronischer Komponenten (nicht gezeigt) auf. Die Leiterplatte 3 ist in dem Gehäuse 2 angeordnet und erstreckt sich wenigstens teilweise zwischen den Öffnungen 20 des Gehäuses 2.

Das elektronische Bauteil 1 weist einen definierten Teilbereich 4 im Inneren und zwischen den beiden Öffnungen 20 des Gehäuses 2 auf. Dieser Teilbereich 4 ist zu den Öffnungen 20 hin durch jeweils eine Schottwand 5 räumlich begrenzt. Die Schottwände 5, wovon in Fig. 1 nur eine (die linke) gezeigt ist, begrenzen zusammen mit dem Gehäuse 2 den Teilbereich im Wesentlichen umfangsseitig geschlossen. Hierzu weist die jeweilige Schottwand 5 bevorzugt eine der zugeordneten Öffnung 20 entsprechende äußere Kontur auf, um möglichst umfangsseitig geschlossen an der Gehäusewand anzuliegen. Auf diese Weise wird ein nach außen hin bevorzugt vollständig abgegrenzter Raum (Teilbereich 4) bereitgestellt, in den wenigstens ein Teil - insbesondere ein elektronische Komponenten aufweisender Teil - der Leiterplatte 3 angeordnet ist.

Der Teilbereich 4 des elektronischen Bauteils 1 ist wenigstens teilweise und bevorzugt vollständig mit einer Vergussmasse ausgefüllt, welche der Übersichtlichkeit halber in Fig. 1 nicht dargestellt ist. Bei dieser Vergussmasse kann es sich um eine Basismatrix wie beispielsweise Asphalt und bevorzugt Silikon oder Polyurethan handeln. Ferner kann die Vergussmasse Füllpartikel aufweisen, die die Viskosität der Basismatrix (z.B. Silikonharz) beeinflussen können (oder durch die die Viskosität der Vergussmasse in gewissen Grenzen beliebig eingestellt werden kann). Als Füllpartikel sind beispielsweise TiO2, SiO2, Al2O3, Polymerteilchen (z.B. Latex) und/oder Glasteilchen einsetzbar. Ebenso können Füllpartikel eingesetzt werden, die (zudem) die Wärmeleitfähigkeit der Vergussmasse verbessern. Durch den umfangsseitig begrenzten Teilbereich 4 kann dieser auf einfache Weise auch mit einer Vergussmasse geringer Viskosität vergossen werden.

Erfindungsgemäß ist wenigstens eine der Schottwände 5 als Sub-Leiterplatte 50 ausgebildet. Auf diese Weise wird es ermöglicht, den zum Zurückhalten der Vergussmasse vorgesehenen Schottwänden einen zusätzlichen Nutzen zu geben, welcher über den Herstellungsprozess des elektronischen Bauteils 1 hinausgeht.

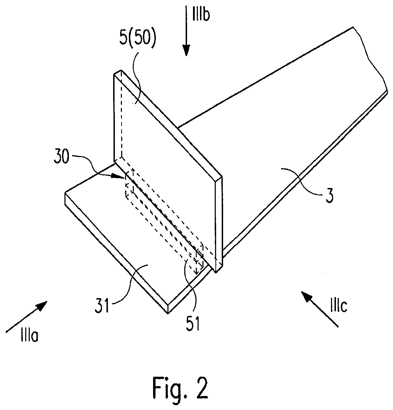

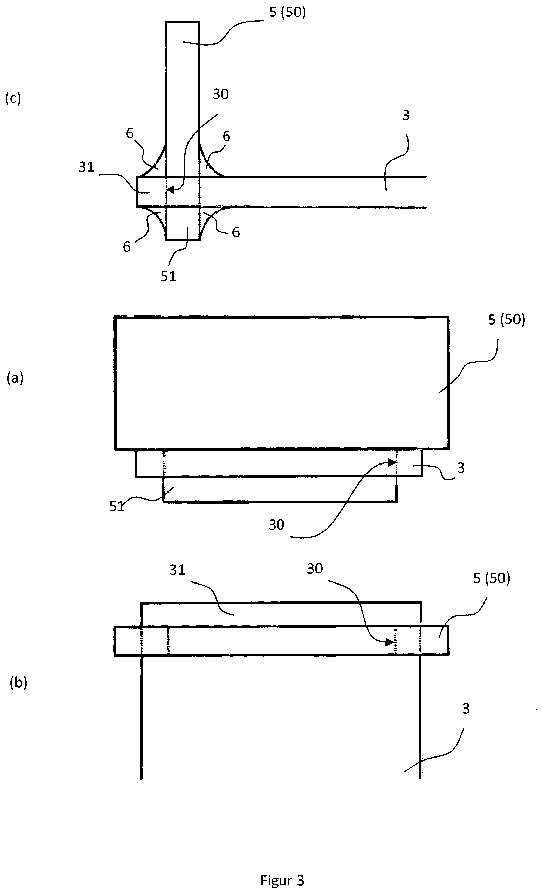

Die Sub-Leiterplatte 50 bzw. die Schottwände 5 können bevorzugt mechanisch mit der Leiterplatte 3 verbunden sein. Gemäß einer bevorzugten Ausgestaltungsform, wie sie in den Figuren 2 und 3 gezeigt ist, kann dabei die Sub-Leiterplatte 50 (bzw. Schottwand 5) einen vorstehenden Bereich 51 aufweisen, welcher in eine korrespondierende Ausnehmung 30 der Leiterplatte 3 eingesetzt ist bzw. eingreift und somit mit dieser mechanisch verbunden ist. Zur sicheren Verbindung der Leiterplatte 3 mit der Sub-Leiterplatte 50 (bzw. Schottwand 5) können diese über Lötbereiche 6 miteinander verlötet sein. Selbstverständlich sind auch andere mechanische Verbindungsarten der Leiterplatte mit den Sub-Leiterplatten 50 bzw. Schottwänden 5 denkbar. Auch können die Leiterplatten 3, 50 (bzw. Schottwand 5) miteinander verklebt oder auf andere formschlüssige, kraftschlüssige und/oder stoffschlüssige Weise miteinander verbunden sein.

Alternativ oder zusätzlich kann die Leiterplatte 3 mit der Sub-Leiterplatte 50 elektrisch verbunden sein. Auf diese Weise kann die nutzbare Leiteroberfläche auf möglichst kompakte Weise bereitgestellt werden, so dass eine Bauraumoptimierung erzielt werden kann. Denn die Leiterplatte 3 kann um die Fläche der Sub-Leiterplatte(n) 50 in der Länge verkürzt werden, welche dann abgewinkelt über die Sub-Leiterplatte(n) 50 zur Verfügung steht und folglich zu einer insgesamt kompakten Bauform des elektronischen Bauteils 1 führt.

Wie insbesondere den Figuren 1 bis 3 zu entnehmen ist, können die Schottwände 5 bzw. Sub-Leiterplatten 50 senkrecht auf der Leiterplatte 3 stehen und/oder sich im Wesentlichen parallel zur Erstreckungsebene der zugeordneten Öffnung 20 erstrecken. Folglich wird der Teilbereich 4 auf flächenmäßig effektive Weise nach außen räumlich begrenzt.

Wie insbesondere Figur 1 zu entnehmen ist, ist die Sub-Leiterplatte 50 wenigstens teilweise seitlich in einer Nut 21 des Gehäuses 2 aufgenommen. Diese Nut 21 ermöglicht nicht nur eine definierte Positionierung der Schottwände 5 bzw. Sub-Leiterplatten 50, sondern sorgt bevorzugt auch für eine verbesserte Dichtfunktion für einen entsprechenden Vergießvorgang aufgrund der bevorzugt dichten Anlage bzw. Aufnahme der Schottwand 5 bzw. Sub-Leiterplatte 50 in der entsprechenden Nut 21. Zudem kann auf diese Weise die durch den Vergießvorgang bzw. die Vergussmasse ausgeübte Druckkraft auf die Schottwand 5 in sicherer Weise durch die Nut 21 bzw. die Anlage der Schottwand 5 in der Nut 21 aufgenommen werden. Eine Nut 21 kann beispielsweise an zwei gegenüberliegenden Gehäusewandabschnitten bzw. -seiten bereitgestellt sein.

Wie insbesondere Figur 1 und Figur 2 zu entnehmen ist, erstreckt sich wenigstens auf einer, vorzugsweise auf beiden gegenüberliegenden Seiten der Leiterplatte 3 ein Bereich 31 der Leiterplatte 3 über die Schottwände 5 bzw. Sub-Leiterplatte 50 nach außen bzw. nach außerhalb des vergossenen Teilbereichs 4. Dieser Bereich 31 der Leiterplatte 3 steht somit von außen bzgl. des elektronischen Bauteils 1 zugänglich bereit. Auf diesen Bereich 31 können folglich Komponenten, also beispielsweise elektrische oder elektronische Komponenten, welche von außen zugänglich bereitgestellt werden müssen, vorgesehen sein, während gleichzeitig durch die Vergussmasse zu schützende Komponenten des elektronischen Bauteils 1 in dem vergossenen Teilbereich 4 bereitgestellt sein können.

Wie Figur 1 zu entnehmen ist, kann die Leiterplatte 3 und/oder die Sub-Leiterplatte 50 wenigstens ein Anschlusselement 7 zum vorzugsweise lösbaren Vorsehen von Kabeln bzw. Leitern aufweisen. Das Anschlusselement 7 ist dabei vorzugsweise außerhalb des vergossenen Teilbereichs 4 vorgesehen und somit auch im vergossenen Zustand des elektronischen Bauteils 1 von außen zugänglich. Dies ist insbesondere bei entsprechenden elektronischen Bauteilen 1 für Leuchten sinnvoll, bei denen bspw. der Treiber bzw. Konverter zum Anschluss an eine Leuchte entsprechend zugängliche Anschlusselemente 7 aufweist.

Um ein Vergießen des elektronischen Bauteils 1 oder das Anordnen bzw. Einsetzen der Leiterplatte 3 bzw. Schottwände 5 oder Sub-Leiterplatte(n) 50 zu vereinfachen, kann das Gehäuse 2 mehrteilig - insbesondere zweiteilig - ausgebildet sein, so dass eine Montageseite zum Anordnen bzw. Einsetzen der Leiterplatte 3 und/oder Schottwände 5 (bzw. Sub-Leiterplatte(n) 50) in den/das Gehäuse wahlweise freigelegt werden kann.

Im vergossenen Zustand kann das Gehäuse 2 bzw. das elektronische Bauteil 1 einer definierten Schutzklasse entsprechen. Hierbei kann es sich beispielsweise um die Schutzklasse IP65 oder auch eine höhere Schutzklasse, bevorzugt (wenigstens) IP67, handeln.

Die Leiterplatte 3 und/oder die Sub-Leiterplatte(n) 50 kann/können elektronische Komponenten aufweisen. Je nachdem, wie das elektronische Bauteil 1 ausgebildet ist, können dabei die Komponenten an unterschiedlichen Bereichen der vorbezeichneten Leiterplatten 3, 50 vorgesehen sein. Beispielsweise ist es denkbar, die Leiterplatte 3 mit Grundkomponenten auszustatten und je nach Anwendungsbereich des elektronischen Bauteils 1 dieses durch Aufsetzen entsprechender Sub-Leiterplatten 50 mit bestimmten elektronischen Komponenten bestückt vorzusehen. Auf diese Weise kann beispielsweise ein elektronisches Bauteil 1 für eine Außenanwendung bereitgestellt werden, welches nach Einsetzen der Leiterplatten 3, 50 in das Gehäuse 2 wenigstens im Teilbereich 4 vergossen wird.

Die Sub-Leiterplatte(n) 50 kann(können) ferner beispielsweise ein RFID-Element aufweisen. Dieses kann bevorzugt einen Mikrochip und eine Antenne aufweisen. Insbesondere kann das RFID-Element für einen Frequenzbereich von 2,4GHz ausgestaltet sein. Wenigstens ein Teil des RFID-Elements, insbesondere die Antenne, kann an der der Vergussmasse bzw. dem Teilbereich 4 abgewandten und vorzugsweise nach außen gewandten Seite der Sub-Leiterplatte 50 vorgesehen sein. Die Antenne ist somit nach außen gerichtet bereitgestellt, was eine gute Funkleistung zur Folge hat gegenüber einer Anordnung einer entsprechenden Antenne innerhalb des Gehäuses 2 bzw. Teilbereichs 4.

Gemäß einem weiteren Aspekt betrifft die Erfindung ferner eine nicht dargestellte Leuchte mit einem erfindungsgemäßen elektronischen Bauteil 1 sowie Leuchtmitteln, insbesondere LEDs, welche zum Betrieb der Leuchte mit dem elektronischen Bauteil 1 elektrisch verbunden sind.

Im Folgenden wird ein Verfahren zur Herstellung eines elektronischen Bauteils 1 beschrieben.

In einem ersten Schritt wird ein Gehäuse 2 mit zwei gegenüberliegenden Öffnungen 20 bereitgestellt.

In einem zweiten Schritt wird eine Leiterplatte 3 zur Aufnahme elektronischer Komponenten in dem Gehäuse 2 angeordnet. Dabei sind die elektronischen Komponenten bevorzugt bereits auf der Leiterplatte 3 angeordnet. Die Leiterplatte 3 wird dabei derart in dem Gehäuse 2 angeordnet, dass sich die Leiterplatte 3 wenigstens teilweise zwischen den Öffnungen 20 des Gehäuses 2 erstreckt.

Des Weiteren werden (zwei) Schottwände 5 derart in dem Gehäuse 2 angeordnet, dass diese Schottwände 5 zusammen mit dem Gehäuse 2 einen definierten Teilbereich 4 im Wesentlichen umfangseitig geschlossen begrenzen, indem sie den Teilbereich 4 jeweils zu den Öffnungen 20 hin räumlich begrenzen. Wenigstens eine der Schottwände 5 ist als Sub-Leiterplatte 50 ausgebildet.

Die Schottwände 5, wenigstens die Sub-Leiterplatte(n) 50, sind mit der Leiterplatte 3 mechanisch verbunden und vorzugsweise mit dieser verlötet. Dies insbesondere, bevor die Leiterplatte 3 mit den verbundenen Schottwänden 5 bzw. Sub-Leiterplatte(n) 50 in dem Gehäuse 2 angeordnet wird. Mit anderen Worten werden gemäß dieser bevorzugten Ausgestaltungsform die Schritte zum Anordnen der Leiterplatte 3 einerseits und Schottwände 5 andererseits in einem gemeinsamen Schritt durchgeführt. Auf diese Weise wird eine automatische Platzierung der Schottwände 5 durch Einsetzen der mit diesen verbundenen Leiterplatte 3 erzielt, was den Montageaufwand reduziert.

Beim Einsetzen der Schottwände 5 und wenigstens der Sub-Leiterplatte(n) 50 werden diese teilweise seitlich in eine Nut 21 des Gehäuses 2 eingesetzt bzw. in dieser geführt. Dies führt zu einer definierten Positionierung der Schottwände 5 einerseits sowie einer verbesserten Dichtfunktion für den Vergießvorgang andererseits. Zudem kann sich die entsprechende Schottwand 5 beim Vergießvorgang in der Nut 21 sicher abstützen, wie dies in Figur 1 deutlich zu erkennen ist.

Zur Vereinfachung der Anordnung der Leiterplatten 3, 50 in dem Gehäuse 2 oder wahlweise auch zur Vereinfachung des Vergießvorganges kann das Gehäuse 2 zweiteilig ausgebildet sein, so dass eine Montageseite zum Anordnen bzw. Einführen der Leiterplatte 3 und/oder Schottwände 5 bzw. Sub-Leiterplatte 50 in dem/das Gehäuse 2 wahlweise freigelegt wird. Vor oder nach dem Vergießvorgang kann das Gehäuse 2 dann verschlossen werden.

Dieser Vergießvorgang bildet den abschließenden Schritt des erfindungsgemäßen Verfahrens. Dabei wird der Teilbereich 4 mit einer Vergussmasse vergossen, welche wenigstens eben diesen Teilbereich 4 zwischen den Öffnungen 20 des Gehäuses 2 ausfüllt. Optional kann ein(e) zusätzliche(r) Aushärtungsphase bzw. Aushärtungsschritt mit wenigstens einem, zwei oder auch mehreren Behandlungsschritten im Anschluss an den oder abwechselnd mit mehreren Vergießvorgängen vorgesehen sein.

Die Erfindung ist nicht auf die vorhergehenden Ausführungsbeispiele beschränkt. So kann es sich bei dem elektronischen Bauteil 1 um alle denkbaren Ausgestaltungsformen entsprechender Bauteile handeln. Auch ist die geometrische Form dieses elektronischen Bauteils 1, des Gehäuses 2, der Leiterplatte 3, der Schottwände 5 und der Sub-Leiterplatte(n) 50 nicht durch die Erfindung beschränkt, solange diese den Teilbereich 4 für einen entsprechenden Vergießvorgang sicher umgeben. Die gegenüberliegenden Enden bzw. Öffnungen 20 müssen dabei nicht auf einer geraden Längsachse des Gehäuses 2 vorgesehen sein. Auch sind die Art der Leiterplatten 3, 50 sowie die darauf vorgesehenen elektronischen Komponenten durch die Erfindung nicht begrenzt. Ebenso ist das Material der Vergussmasse durch die Erfindung nicht begrenzt.

## Patentansprüche

1. Elektronisches Bauteil (1), insbesondere Treiber für eine Leuchte, aufweisend:
ein Gehäuse (2) mit zwei gegenüberliegenden Öffnungen (20),
eine Leiterplatte (3) zur Aufnahme elektronischer Komponenten, welche in dem Gehäuse (2) angeordnet ist und sich wenigstens teilweise zwischen den Öffnungen (20) des Gehäuses (2) erstreckt, und
eine Vergussmasse, welche einen definierten Teilbereich (4) zwischen den Öffnungen (20) des Gehäuses (2) ausfüllt,
wobei der Teilbereich (4) zu den Öffnungen (20) hin durch jeweils eine Schottwand (5) räumlich begrenzt ist, welche zusammen mit dem Gehäuse (2) den Teilbereich (4) im Wesentlichen umfangsseitig geschlossenen begrenzen,
wobei wenigstens eine der Schottwände (5) als Sub-Leiterplatte (50) ausgebildet ist, und
wobei wenigstens die Sub-Leiterplatte (50) wenigstens teilweise seitlich in einer Nut (21) des Gehäuses (2) aufgenommen ist.

2. Elektronisches Bauteil (1) nach Anspruch 1, wobei die Sub-Leiterplatte (50) mechanisch und/oder elektrisch mit der Leiterplatte (3) verbunden ist, und/oder
wobei die Schottwände (5), wenigstens die Sub-Leiterplatte(n) (50), mit der Leiterplatte (3) verlötet sind.

3. Elektronisches Bauteil (1) nach einem der vorhergehenden Ansprüche, wobei die Schottwände (5), wenigstens die Sub-Leiterplatte(n) (50), vorzugsweise senkrecht auf der Leiterplatte (3) stehen und/oder sich im Wesentlichen parallel zur Erstreckungsebene der zugeordneten Öffnung (20) erstrecken.

4. Elektronisches Bauteil (1) nach einem der vorhergehenden Ansprüche, wobei die Schottwände (5) wenigstens teilweise seitlich in einer Nut (21) des Gehäuses (2) aufgenommen sind.

5. Elektronisches Bauteil (1) nach einem der vorhergehenden Ansprüche, wobei wenigstens auf einer, vorzugsweise auf gegenüberliegenden Seite der Leiterplatte (3) sich ein Bereich (31) der Leiterplatte (3) über die Schottwände (5) nach außerhalb des vergossenen Teilbereichs (4) erstreckt.

6. Elektronisches Bauteil (1) nach einem der vorhergehenden Ansprüche, wobei die Leiterplatte (3) und/oder die Sub-Leiterplatte(n) (50) elektronische Komponenten aufweisen, und/oder
wobei die Sub-Leiterplatte(n) (50) ein RFID-Element vorzugsweise mit Mikrochip und Antenne aufweist, wobei wenigstens ein Teil des RFID-Elements, insbesondere die Antenne, an der der Vergussmasse bzw. dem Teilbereich (4) abgewandten und vorzugsweise nach außen gewandten Seite der Sub-Leiterplatte (50) vorgesehen ist, und/oder
wobei die Sub-Leiterplatte(n) (50) Filterkomponenten einer Überspannungsschutzeinheit aufweisen, und/oder
wobei die Leiterplatte (3) und/oder Sub-Leiterplatte(n) (50) wenigstens ein Anschlusselement (7) zum vorzugsweise lösbaren Vorsehen von Leitern aufweist, wobei das Anschlusselement (7) vorzugsweise außerhalb des vergossenen Teilbereichs (4) vorgesehen ist.

7. Elektronisches Bauteil (1) nach einem der vorhergehenden Ansprüche, wobei das Gehäuse (2) zweiteilig ausgebildet ist, so dass eine Montageseite zum Anordnen der Leiterplatte (3) und/oder Schottwände (5, 50) in dem Gehäuse (2) wahlweise freigelegt werden kann, und/oder
wobei das vergossene Gehäuse (2) einer definierten Schutzklasse entspricht, vorzugsweise wenigstens IP65, ferner bevorzugt wenigstens IP67.

8. Elektronisches Bauteil (1) nach einem der vorhergehenden Ansprüche, wobei die Vergussmasse eine Basismatrix wie beispielsweise Asphalt, Silikon, insbesondere Silikonharz, oder Polyurethan aufweist, wobei die Vergussmasse bevorzugt Füllpartikel aufweist, die beispielsweise die Viskosität der Basismatrix beeinflusst oder einstellt und/oder die Wärmeleitfähigkeit der Vergussmasse erhöht, wie vorzugsweise TiO2, SiO2, Al2O3, Polymerteilchen, wie z.B. Latex, und/oder Glasteilchen einsetzbar.

9. Elektronisches Bauteil (1) nach einem der vorhergehenden Ansprüche, wobei das elektronische Bauteil (1) ein Treiber, insbesondere ein LED-Treiber, für eine Leuchte ist.

10. Leuchte aufweisend ein elektronisches Bauteil (1) nach einem der vorhergehenden Ansprüche sowie ein Leuchtmittel, insbesondere eine LED, welche(s) zum Betrieb der Leuchte mit dem elektronischen Bauteil (1) elektrisch verbunden ist.

11. Verfahren zur Herstellung eines elektronischen Bauteils (1), aufweisend die folgenden Schritte:
- Bereitstellen eines Gehäuses (2) mit zwei gegenüberliegenden Öffnungen (20),
- Anordnen einer Leiterplatte (3) zur Aufnahme elektronischer Komponenten in dem Gehäuse (2), so dass sich die Leiterplatte (3) wenigstens teilweise zwischen den Öffnungen (20) des Gehäuses (2) erstreckt,
- Anordnen von Schottwände (5) in dem Gehäuse (2) derart, dass diese zusammen mit dem Gehäuse (2) einen definierten Teilbereich (4) im Wesentlichen umfangsseitig geschlossenen begrenzen, indem sie den Teilbereich (4) jeweils zu den Öffnungen (20) hin räumlich begrenzen, wobei wenigstens eine der Schottwände (5) als Sub-Leiterplatte (50) ausgebildet ist, und wobei wenigstens die Sub-Leiterplatte (50) wenigstens teilweise seitlich in eine Nut (21) des Gehäuses (2) eingesetzt wird, und
- Vergießen des Teilbereichs (4) mit einer Vergussmasse, welche wenigstens den Teilbereich (4) zwischen den Öffnungen (20) des Gehäuses (2) ausfüllt.

12. Verfahren nach Anspruch 11, wobei die Schottwände (5), wenigstens die Sub-Leiterplatte(n) (50), mit der Leiterplatte (3) mechanisch verbunden wird, vorzugsweise verlötet, besonders vorzugsweise bevor die Leiterplatte (3) mit den verbundenen Schottwänden (5) bzw. Sub-Leiterplatte(n) (50) in dem Gehäuse (2) angeordnet wird.

13. Verfahren nach Anspruch 11 oder 12, wobei die Schottwände (5) wenigstens teilweise seitlich in eine Nut (21) des Gehäuses (2) eingesetzt werden.

14. Verfahren nach einem der Ansprüche 11 bis 13, wobei das Gehäuse (2) zweiteilig ausgebildet ist, so dass eine Montageseite zum Anordnen der Leiterplatte (3) und/oder Schottwände (5) bzw. Sub-Leiterplatte(n) (50) in dem Gehäuse (2) wahlweise freigelegt wird.

15. Verfahren nach einem der Ansprüche 11 bis 14, wobei dem Schritt zum Vergießen des Teilbereichs ein Aushärtungsschritt zum Aushärten der Vergussmasse folgt, wobei vorzugsweise mehrere Aushärtungsschritte bevorzugt abwechselnd zu mehreren Vergießschritten angewendet werden.

## Claims

1. Electronic element (1), in particular a driver for a lamp, comprising:
a housing (2) having two opposite openings (20),
a circuit board (3) for receiving electronic components, which is disposed in the housing (2) and extends at least partly between the openings (20) of the housing (2), and
a casting compound, which fills a defined subregion (4) between the openings (20) of the housing (2),
wherein the subregion (4) is spatially delimited toward the openings (20) by a respective partition wall (5), which together with the housing (2) delimits the subregion (4) in a substantially peripherally closed manner, wherein at least one of the partition walls (5) is configured as a sub-circuit board (50), and
wherein at least the sub-circuit board (50) is at least partially received laterally in a groove (21) of the housing (2) .

2. Electronic element (1) according to Claim 1, wherein the sub-circuit board (50) is mechanically and/or electrically connected to the circuit board (3), and/or
wherein the partition walls (5), at least the sub-circuit board(s) (50), are soldered to the circuit board (3).

3. Electronic element (1) according to any one of the preceding claims, wherein the partition walls (5), at least the sub-circuit board(s) (50), are preferably perpendicular to the circuit board (3) and/or extend substantially parallel to the extension plane of the associated opening (20).

4. Electronic element (1) according to any one of the preceding claims, wherein the partition walls (5) are at least partially received laterally in a groove (21) of the housing (2).

5. Electronic element (1) according to any one of the preceding claims, wherein on at least one, preferably opposite, side of the circuit board (3), a region (31) of the circuit board (3) extends beyond the partition walls (5) to the outside of the cast subregion (4).

6. Electronic element (1) according to any one of the preceding claims, wherein
the circuit board (3) and/or the sub-circuit board(s) (50) comprise electronic components, and/or
wherein the sub-circuit board(s) (50) comprises an RFID element, preferably having a microchip and an antenna, wherein at least a part of the RFID element, in particular the antenna, is provided on the side of the sub-circuit board (50) which faces away from the casting compound or the subregion (4) and preferably faces outward, and/or
wherein the sub-circuit board(s) (50) comprise filter components of an overvoltage protection unit, and/or
wherein the circuit board (3) and/or the sub-circuit board(s) (50) comprises at least one connecting element (7) for preferably releasably providing conductors, wherein the connecting element (7) is preferably provided outside the cast subregion (4).

7. Electronic element (1) according to any one of the preceding claims, wherein the housing (2) is configured in two parts, so that an assembly side for disposing the circuit board (3) and/or the partition walls (5, 50) in the housing (2) can selectively be exposed, and/or
wherein the cast housing (2) complies with a defined protection class, preferably at least IP65, further preferably at least IP67.

8. Electronic element (1) according to any one of the preceding claims, wherein the casting compound comprises a base matrix such as asphalt, silicone, in particular silicone resin, or polyurethane, wherein the casting compound preferably comprises filler particles such as preferably TiO₂, SiO₂, Al₂O₃, polymer particles, such as latex, and/or glass particles, which, for example, affect or set the viscosity of the base matrix and/or increase the thermal conductivity of the casting compound.

9. Electronic element (1) according to any one of the preceding claims, wherein the electronic element (1) is a driver, in particular an LED driver, for a lamp.

10. Lamp comprising an electronic element (1) according to any one of the preceding claims and a lighting means, in particular an LED, which is electrically connected to the electronic element (1) for operating the lamp.

11. Method for producing an electronic element (1) comprising the following steps:
- providing a housing (2) having two opposite openings (20),
- disposing a circuit board (3) for receiving electronic components in the housing (2) such that the circuit board (3) extends at least partly between the openings (20) of the housing (2),
- disposing partition walls (5) in the housing (2) such that, together with the housing (2), they delimit a defined subregion (4) in a substantially peripherally closed manner by respectively spatially delimiting the subregion (4) toward the openings (20), wherein at least one of the partition walls (5) is configured as a sub-circuit board (50) and wherein at least the sub-circuit board (50) is at least partially inserted laterally into a groove (21) of the housing (2), and
- casting the subregion (4) with a casting compound, which fills at least the subregion (4) between the openings (20) of the housing (2).

12. Method according to Claim 11, wherein the partition walls (5), at least the sub-circuit board(s) (50), are mechanically connected to the circuit board (3), preferably soldered, particularly preferably before the circuit board (3) with the connected partition walls (5) or sub-circuit board(s) (50) is disposed in the housing (2).

13. Method according to Claim 11 or 12, wherein the partition walls (5) are at least partially inserted laterally into a groove (21) of the housing (2).

14. Method according to any one of Claims 11 to 13, wherein the housing (2) is configured in two parts, so that an assembly side for disposing the circuit board (3) and/or the partition walls (5) or sub-circuit board(s) (50) in the housing (2) is selectively exposed.

15. Method according to any one of Claims 11 to 14, wherein the step for casting the subregion is followed by a curing step for curing the casting compound, wherein a plurality of curing steps are preferably used, preferably alternating with a plurality of casting steps.

## Revendications

1. Dispositif électronique (1), notamment appareillage destiné à un luminaire, présentant :
un boîtier (2) doté de deux ouvertures (20) opposées,
une carte de circuit imprimé (3) destinée à recevoir des composants électroniques et disposée dans le boîtier (2) en s'étendant au moins partiellement entre les ouvertures (20) du boîtier (2), et
un matériau d'enrobage qui comble une zone partielle (4) définie, entre les ouvertures (20) du boîtier (2) ;
ladite zone partielle (4) étant spatialement délimitée, vers les ouvertures (20), par une paroi de séparation (5) respective qui, avec le boîtier (2), délimite une zone partielle (4) sensiblement fermée sur son pourtour, l'une au moins des parois de séparation (5) servant de carte de circuit imprimé secondaire (50), et
au moins ladite carte de circuit imprimé secondaire (50) étant reçue au moins partiellement, par ses côtés, dans une rainure (21) du boîtier (2).

2. Dispositif électronique (1) selon la revendication 1, dans lequel la carte de circuit imprimé secondaire (50) est reliée mécaniquement et/ou électriquement à la carte de circuit imprimé (3), et/ou
dans lequel les parois de séparation (5), au moins la ou les cartes de circuit imprimé secondaires (50), sont soudées à la carte de circuit imprimé (3).

3. Dispositif électronique (1) selon l'une des revendications précédentes, dans lequel les parois de séparation (5), au moins la ou les cartes de circuit imprimé secondaires (50), sont disposées verticalement sur la carte de circuit imprimé (3) et/ou s'étendent de manière sensiblement parallèle au plan selon lequel s'étend l'ouverture (20) associée.

4. Dispositif électronique (1) selon l'une des revendications précédentes, dans lequel les parois de séparation (5) sont reçues sur leurs côtés, au moins partiellement, dans une rainure (21) du boîtier (2).

5. Dispositif électronique (1) selon l'une des revendications précédentes, dans lequel au moins une zone (31) de la carte de circuit imprimé (3), située sur au moins un côté et de préférence sur les deux côtés opposés de la carte de circuit imprimé (3), s'étend, en passant par les parois de séparation (5), vers l'extérieur de la zone partielle (4) ayant reçu le matériau d'enrobage.

6. Dispositif électronique (1) selon l'une des revendications précédentes, dans lequel
la carte de circuit imprimé (3) et/ou la ou les cartes de circuit imprimé secondaires (50) présentent des composants électroniques et/ou
dans lequel la ou les cartes de circuit imprimé secondaires (50) présentent un élément RFID de préférence doté d'une micropuce et d'une antenne, au moins une partie de l'élément RFID, notamment l'antenne, étant prévue sur le côté de la carte de circuit imprimé secondaire (50) qui est opposé à celui où se trouve le matériau d'enrobage ou la zone partielle (4) et qui est de préférence tourné vers l'extérieur, et/ou dans lequel la ou les cartes de circuit imprimé secondaires (50) présentent des composants filtrants d'une unité de protection contre la surtension, et/ou
dans lequel la carte de circuit imprimé (3) et/ou la ou les cartes de circuit imprimé secondaires (50) présentent au moins un élément de raccordement (7) permettant la présence, de préférence de façon amovible, de conducteurs, ledit élément de raccordement (7) étant prévu de préférence en dehors de la zone partielle (4) ayant reçu le matériau d'enrobage.

7. Dispositif électronique (1) selon l'une des revendications précédentes, dans lequel le boîtier (2) est conçu en deux parties, si bien qu'un côté de montage servant à l'agencement de la carte de circuit imprimé (3) et/ou des parois de séparation (5, 50) dans le boîtier (2) puissent être sélectivement dégagées, et/ou
dans lequel le boîtier (2) ayant reçu le matériau d'enrobage répond à une classe de protection définie, de préférence au moins IP65, tout particulièrement au moins IP67.

8. Dispositif électronique (1) selon l'une des revendications précédentes, dans lequel le matériau d'enrobage présente une matrice de base, par exemple de l'asphalte ou de la silicone, notamment de la résine de silicone, ou bien du polyuréthane, ledit matériau d'enrobage présentant de préférence des particules de charge qui, par exemple, influent sur la viscosité de la matrice de base ou permettent de l'adapter, et/ou qui augmentent la capacité de conduction thermique du matériau d'enrobage, telles que TiO2, SiO2, Al2O3, des particules polymères telles que par ex. du latex et/ou des particules de verre.

9. Dispositif électronique (1) selon l'une des revendications précédentes, dans lequel le dispositif électronique (1) est un appareillage, notamment pour LED, destiné à un luminaire.

10. Luminaire présentant un dispositif électronique (1) selon l'une des revendications précédentes, ainsi qu'un moyen d'éclairage, notamment une LED, relié électriquement au dispositif électronique (1) pour faire fonctionner le luminaire.

11. Procédé de fabrication d'un dispositif électronique (1) présentant les étapes suivantes consistant à :
- fournir un boîtier (2) doté de deux ouvertures (20) opposées,
- agencer, dans le boîtier (2), une carte de circuit imprimé (3) destinée à recevoir des composants électroniques de telle façon que la carte de circuit imprimé (3) s'étende au moins partiellement entre les ouvertures (20) du boîtier (2) ,
- agencer des parois de séparation (5) dans le boîtier (2) de telle façon que celles-ci, avec le boîtier (2), délimitent une zone partielle (4) définie, sensiblement fermée sur son pourtour, celles-ci délimitant spatialement la zone partielle (4), chacune vers les ouvertures (20), l'une au moins des parois de séparation (5) servant de carte de circuit imprimé secondaire (50), et au moins ladite carte de circuit imprimé secondaire (50) étant introduite au moins partiellement, par ses côtés, dans une rainure (21) du boîtier (2), et
- faire couler dans la zone partielle (4) un matériau d'enrobage comblant au moins la zone partielle (4) entre les ouvertures (20) du boîtier (2).

12. Procédé selon la revendication 11, dans lequel les parois de séparation (5), au moins la ou les cartes de circuit imprimé secondaires (50), sont reliées mécaniquement à la carte de circuit imprimé (3), en étant de préférence soudées à celle-ci, plus préférablement avant l'agencement, dans le boîtier (2), de la carte de circuit imprimé (3) dotée des parois de séparation (5) ou de la ou des cartes de circuit imprimé secondaires (50) qui y sont reliées.

13. Procédé selon la revendication 11 ou 12, dans lequel les parois de séparation (5) sont placées au moins partiellement, par leurs côtés, dans une rainure (21) du boîtier (2).

14. Procédé selon l'une des revendications 11 à 13, dans lequel le boîtier (2) est conçu en deux parties, si bien qu'un côté de montage servant à l'agencement de la carte de circuit imprimé (3) et/ou des parois de séparation (5) ou de la ou des cartes de circuit imprimé secondaires (50) dans le boîtier (2) soit sélectivement dégagé.

15. Procédé selon l'une des revendications 11 à 14, dans lequel l'étape consistant à faire couler un matériau d'enrobage dans la zone partielle est suivie d'une étape de durcissement destinée à faire durcir le matériau d'enrobage, plusieurs étapes de durcissement étant de préférence mises en œuvre, de préférence de façon alternée à plusieurs étapes de coulée de matériau d'enrobage.
